## Europäisches Patentamt

## European Patent Office

## Office européen des brevets

(19)

(11) Veröffentlichungsnummer: **0 076 963**
**B1**

(12)

# EUROPÄISCHE PATENTSCHRIFT

(45) Veröffentlichungstag der Patentschrift:
07.01.87

(51) Int. Cl.⁴: **G 05 F 3/20**

(21) Anmeldenummer: **82108937.2**

(22) Anmeldetag: **27.09.82**

(54) Schaltungsanordnung zur Erzeugung eines von Schwankungen einer Versorgungsgleichspannung freien Gleichspannungspegels.

(30) Priorität: **28.09.81 DE 3138558**

(43) Veröffentlichungstag der Anmeldung:
**20.04.83 Patentblatt 83/16**

(45) Bekanntmachung des Hinweises auf die Patenterteilung:
**07.01.87 Patentblatt 87/2**

(84) Benannte Vertragsstaaten:
**AT DE FR GB IT**

(56) Entgegenhaltungen:
**EP - A - 0 029 231**

**IBM TECHNICAL DISCLOSURE BULLETIN, Band 23, Nr. 5, Oktober 1980, Seiten 1840-1841, New York, USA R.S. BECKER: "Voltage reference circuit"**
**IBM TECHNICAL DISCLOSURE BULLETIN, Band 14, Nr. 7, Dezember 1971, Seiten 2088-2089, New York, USA H.O. ASKIN et al.: "FET device parameters compensation circuit"**

(73) Patentinhaber: **Siemens Aktiengesellschaft Berlin und München, Wittelsbacherplatz 2, D-8000 München 2 (DE)**

(72) Erfinder: **Goetz, Jürgen Rolf, Dr. Dipl.-Phys., Finkenweg 3, D-8059 Oberneuching (DE)**

**Beschreibung**

Die Erfindung betrifft eine Schaltungsanordnung zur Erzeugung eines von Schwankungen einer Versorgungsgleichspannung freien Gleichspannungspegels nach dem Oberbegriff des Patentanspruches 1.

Aus der EP-A 0 029 231 ist eine gattungsgemässe Referenzspannungsquelle bekannt. Sie weist in einem Spannungsteiler zwei Abgriffe für zwei verschiedene interne Referenzspannungen auf. Weiters enthält sie zwei Reihenschaltungen von MOS-Transistoren, deren eine an den Gates gemeinsam von einer der beiden internen Referenzspannungen angesteuert wird. Ein Transistor der anderen Reihenschaltung wird gatemässig von der zweiten internen Referenzspannung angesteuert, das Gate des anderen Transistors der anderen Reihenschaltung ist mit der Versorgungsspannung verbunden. Über einen Transistor sind die Ausgänge der beiden Reihenschaltungen zu einem einzigen gemeinsamen Ausgang zusammengekoppelt. Diese bekannte Schaltung benötigt zu ihrer Realisierung eine relativ grosse Fläche. Ausserdem weist diejenige der internen Referenzspannungen, deren Spannungswert näher am Bezugspotential liegt als an der Versorgungsspannung, aufgrund der geringen Anzahl an Transistoren zwischen dem der internen Referenzspannung zugehörigen Abgriff und dem Bezugspotential relativ grosse Spannungsschwankungen sowie eine relativ grosse Abhängigkeit von technologisch bedingten Einsatzspannungsänderungen auf.

Dies wirkt sich negativ auf die nachgeschaltete Reihenschaltung von MOS-Transistoren aus.

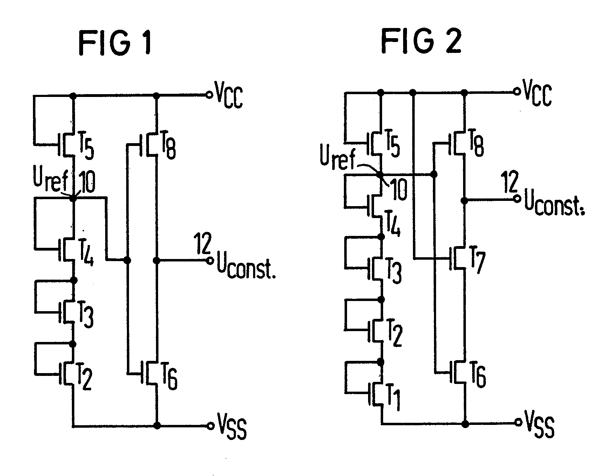

Eine bisher verwendete Schaltungsanordnung der vorgenannten Art ist in Fig. 1 dargestellt. In dieser Schaltungsanordnung liegt zwischen einer in der Praxis mit Schwankungen behafteten Versorgungsgleichspannung $V_{cc}$ und Bezugspotential $V_{ss}$ ein durch MOS-Transistoren $T_2$ bis $T_5$ gebildeter Spannungsteiler. Ein durch die Transistoren $T_2$ bis $T_4$ gebildeter Zweig dieses Spannungsteilers liegt zwischen einem Abgriff 10 für eine Referenzspannung $U_{ref}$ und einem Bezugspotential $V_{ss}$, während ein weiterer durch einen Transistor $T_5$ gebildeter Zweig zwischen dem Abgriff 10 und der Versorgungsgleichspannung $V_{cc}$ liegt. Die Transistoren $T_2$ bis $T_5$ des Spannungsteilers sind dabei dadurch als Widerstand bzw. als Diode geschaltet, dass ihr Gate und ihre Drain direkt miteinander verbunden sind. Ob ein derartig geschalteter Transistor primär als Diode oder als Widerstand arbeitet, hängt davon ab, in wie weit seine Kennlinie als linear betrachtet wird.

Zwischen der Versorgungsgleichspannung $V_{cc}$ und Bezugspotential $V_{ss}$ liegt die Reihenschaltung zweier weiterer MOS-Transistoren $T_6$ und $T_8$, die an ihren Gates gemeinsam von der Referenzspannung $U_{ref}$ am Abgriff 10 des Spannungsteilers angesteuert werden. Der Verbindungspunkt dieser beiden Transistoren $T_6$ und $T_8$ bildet einen Ausgang 12, an dem ein weitgehend konstanter Gleichspannungspegel $U_{const}$ abnehmbar ist.

Bei einer Schwankung der Versorgungsgleichspannung $V_{cc}$ schwankt zunächst die Referenzspannung $U_{ref}$ am Abgriff 10 des Spannungsteilers und damit auch der Widerstand der Transistoren $T_6$ und $T_8$, so dass auch der Gleichspannungspegel am Ausgang 12 schwankt. Zwar lässt sich mit der Schaltungsanordnung nach Fig. 1 bei einer Versorgungsgleichspannung $V_{cc} = 5$ Volt und entsprechender Dimensionierung der Transistoren ein Gleichspannungspegel von 1,5 Volt einstellen. Schwankt die Versorgungsspannung jedoch um $\pm$ 1 Volt, so schwankt der Gleichspannungspegel am Ausgang 12 um $\pm$ 13%, wobei für Änderungen der Einsatzspannung der Transistoren keine Kompensation möglich ist.

Der vorliegenden Erfindung liegt die Aufgabe zugrunde, eine einfachere Schaltungsanordnung der in Rede stehenden Art anzugeben, bei welcher der Ausgangs-Gleichspannungspegel unabhängiger von Schwankungen der Versorgungsgleichspannung und technologisch bedingten Einsatzspannungsänderungen der verwendeten MOS-Transistoren ist.

Diese Aufgabe wird bei einer gattungsgemässen Schaltungsanordnung durch die kennzeichnenden Merkmale des Patentanspruches 1 gelöst.

In Weiterbildung der Erfindung wird dabei die Einsatzspannung der MOS-Transistoren im Zweig des Spannungsteilers zwischen Abgriff und Bezugspotential durch Vergrösserung ihrer Kanallänge erhöht.

Die Erfindung wird im folgenden anhand eines in Fig. 2 der Zeichnung dargestellten Ausführungsbeispiels näher erläutert. Fig. 2 zeigt dabei ein Schaltbild einer erfindungsgemässen Schaltungsanordnung. Gleiche Elemente wie in der Schaltungsanordnung nach Fig. 1 sind dabei mit gleichen Bezugszeichen versehen.

Wie Fig. 2 zeigt, ist in den Spannungsteiler ein weiterer als Diode bzw. als Widerstand geschalteter Transistor $T_1$ eingefügt, während in den aus den Transistoren $T_6$ und $T_8$ gebildeten Zweig ein Transistor $T_7$ eingefügt ist, welcher von der Versorgungsgleichspannung $V_{cc}$ angesteuert wird. Der Ausgang 12 der Schaltungsanordnung wird durch den Verbindungspunkt der Transistoren $T_7$ und $T_8$ gebildet.

Durch Erhöhung der Zahl der Transistoren im Spannungsteilerzweig zwischen dem Abgriff 10 und Bezugspotential $V_{ss}$ wird der Pegel der Referenzspannung $U_{ref}$ am Abgriff 10 angehoben, wodurch der Transistor $T_5$ im anderen Spannungsteilerzweig hochohmiger gemacht werden kann. Damit wird insgesamt eine Vorstabilisierung der Pegelhöhe des Gleichspannungspegels $U_{const}$ am Ausgang 12 erreicht. Durch Vergrösserung der Kanallänge der Transistoren $T_1$ bis $T_4$ im Spannungsteiler wird die Einsatzspannung dieser Transistoren erhöht, wodurch eine Stabilisierung der Referenzspannung $U_{ref}$ am Abgriff 10 erreicht wird.

Da der Transistor $T_7$ entsprechend von Schwankungen der Versorgungsspannung $V_{cc}$ seinen Widerstandswert ändert, wird eine weitere Kompensation von Versorgungsgleichspannungs-Schwankungen erreicht, da der Ausgangsgleichspannungs-Pegel $U_{const}$ über den Transistor $T_7$ bei fallender Versorgungsgleichspannung $V_{cc}$ ange-hoben und bei steigender Versorgungsgleich-spannung $V_{cc}$ abgesenkt wird.

Der Transistor $T_6$ wirkt weiterhin im Sinne einer Kompensation von technologisch bedingten Einsatzspannungsänderungen.

Bei entsprechender Dimensionierung der Transistoren ist der Gleichspannungspegel $U_{const}$ bei Schwankungen der Versorgungsgleichspannung von $\pm$ 1 Volt bis auf Schwankungen kleiner $\pm$ 1% stabil. Weiterhin lässt sich der Gleichspannungspegel $U_{const}$ bei technologisch bedingten Einsatzspannungsänderungen in einem Bereich von $- 100$ mV $+ U_T$ bis $U_T + 300$ mV auf kleiner $\pm$ 1% stabilisieren. $U_T$ bedeutet dabei die Einsatzspan-nung der Transistoren.

**Patentanspruch**

1. Schaltungsanordnung zur Erzeugung eines von Schwankungen einer Versorgungsgleich-spannung freien Gleichspannungspegels mit ei-nem an der Versorgungsspannung liegenden Spannungsteiler aus MOS-Transistoren, in dem in einem Zweig zwischen einem Abgriff für eine Re-ferenzspannung und Bezugspotential eine Rei-henschaltung von mindestens vier MOS-Transistoren liegt, und mit einer zwischen Versorgungsgleichspannung und Bezugspotential liegenden Reihenschaltung von MOS-Transistoren, die gemeinsam von der Referenzspannung am Abgriff des Spannungsteilers angesteuert sind, dadurch gekennzeichnet, dass beim Spannungsteiler ($T_1$ bis $T_5$) nur ein einziger Abgriff (10) für eine einzige Referenzspannung ($U_{ref}$) vorgesehen ist und dass zwischen die in die Reihenschaltung der gemeinsam von der Referenzspannung ($U_{ref}$) angesteuer-ten Transistoren ($T_6$, $T_8$) ein von der Versorgungs-gleichspannung ($V_{cc}$) angesteuerter MOS-Transi-stor ($T_7$) eingeschaltet ist.

**Claim**

A circuit arrangement for the generation of a d.c. supply voltage having a stable voltage level, with a voltage divider composed of MOS-transistors connected to the supply voltage, a series arrangement of at least four MOS-transistors in an arm between a tapping for a reference voltage and a reference potential point, and a series arrangement of MOS-transistors connected between the d.c. supply voltage and reference potential point and commonly driven by the reference voltage connected to the tapping of the voltage divider, characterised in that only one single tapping (10) is provided in the voltage divider ($T_1$ to $T_5$) for one single reference voltage ($U_{ref}$) and that a MOS-transistor ($T_7$), driven by the d.c. supply voltage ($V_{cc}$), is connected into the series arrangement of the transistors ($T_6$, $T_8$) which are commonly driven by the reference voltage ($U_{ref}$).

**Revendication**

1. Montage pour produire un niveau de tension continue libre des variations d'une tension continue d'alimentation, comportant, relié à la tension d'alimentation, un diviseur de tension constitué par des transistors MOS, dans lequel il est prévu, dans une branche située entre une prise pour une tension de référence et le potentiel de référence, un circuit série constitué par au moins quatre transistors MOS, ainsi qu'un circuit série de transistors MOS, monté entre la tension continue d'alimentation et le potentiel de référence, et qui sont attaqués en commun par la tension de référence au niveau de la prise du diviseur de tension, caractérisé par le fait que le diviseur de tension ($T_1$ à $T_5$) ne comporte qu'une prise unique (8) pour une seule tension de référence ($U_{ref}$), et qu'entre les transistors ($T_6$, $T_8$) attaqués en commun par la tension de référence ($U_{ref}$) dans le circuit série, est monté un transistor MOS ($T_7$) attaqué par la tension continue d'alimentation.

# FIG 1

# FIG 2